(19) 

Europäisches
Patentamt
European
Patent Office
Office européen
des brevets

(11) **EP 2 557 429 A1**

(12) **EUROPEAN PATENT APPLICATION**
published in accordance with Art. 153(4) EPC

(43) Date of publication:
**13.02.2013 Bulletin 2013/07**

(21) Application number: **11780673.7**

(22) Date of filing: **12.05.2011**

(51) Int Cl.:
***G01R 33/04*** *(2006.01)*

(86) International application number:
**PCT/JP2011/060939**

(87) International publication number:
**WO 2011/142416 (17.11.2011 Gazette 2011/46)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **12.05.2010 JP 2010110229**

(71) Applicant: **Fujikura, Ltd.
Tokyo 135-8512 (JP)**

(72) Inventor: **OHMORI Kenichi
Chiba 285-8550 (JP)**

(74) Representative: **Cabinet Plasseraud
52, rue de la Victoire
75440 Paris Cedex 09 (FR)**

(54) **METHOD FOR MANUFACTURING FLUX GATE SENSOR**

(57)     Provided is a manufacturing method of a flux gate sensor comprising at least: a first step of forming a first wiring layer on a substrate; a second step of forming a first insulating layer made of a first resin to cover the first wiring layer; a third step of forming a magnetic layer on the first insulating layer, the magnetic layer constituting a core of a flux gate; a fourth step of forming a second insulating layer made of a second resin on the first insulating layer to cover the magnetic layer; and a fifth step of forming a second wiring layer on the second insulating layer, wherein the first wiring layer and the second wiring layer are electrically connected to each other so that each of the first wiring layer and the second wiring layer constitutes a magnetic coil and a pickup coil, and at least a process temperature in each of the third, fourth, and fifth steps is lower than a glass transition temperature of the first resin.

FIG. 1

**EP 2 557 429 A1**

## Description

TECHNICAL FIELD

The present invention relates to a manufacturing method of a flux gate sensor. Specifically, the present invention relates to a manufacturing method of a thin film flux gate sensor employed in an electronic azimuth meter used in a cellular phone and the like.
Priority is claimed on Japanese Patent Application No. 2010-110229, filed May 12, 2010, the content of which is incorporated herein by reference.

BACKGROUND ART

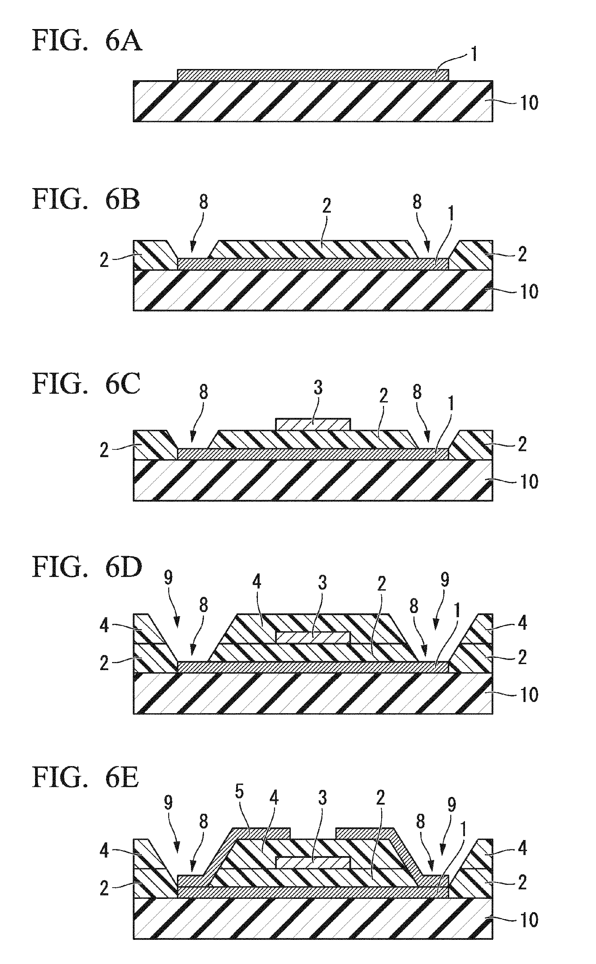

An electronic azimuth meter has been used in a cellular phone, a portable navigation device, a game controller and the like. In order to miniaturize the entirety of an apparatus, demands for the electronic azimuth meter to achieve a small size and integration have been increasing. In order to achieve the small size and integration, replacing a sensor used in the electronic azimuth meter with a thin film flux gate sensor has been considered.

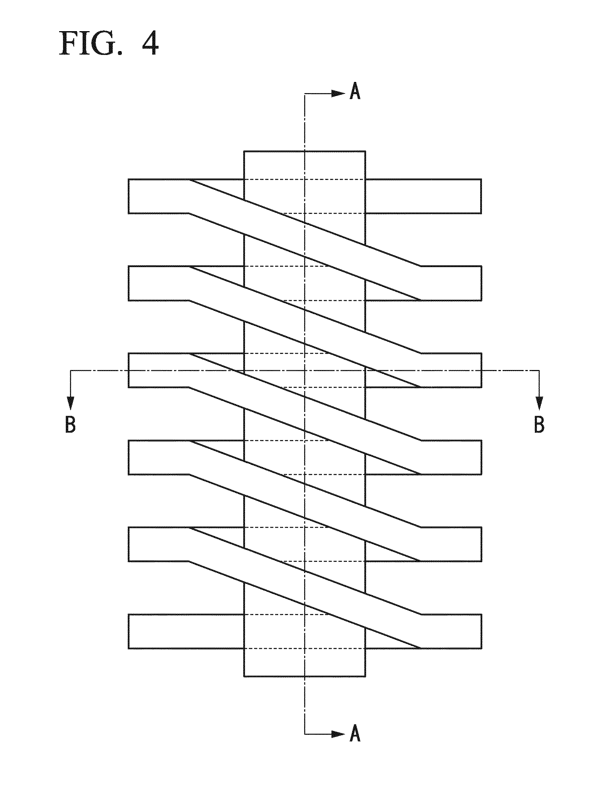

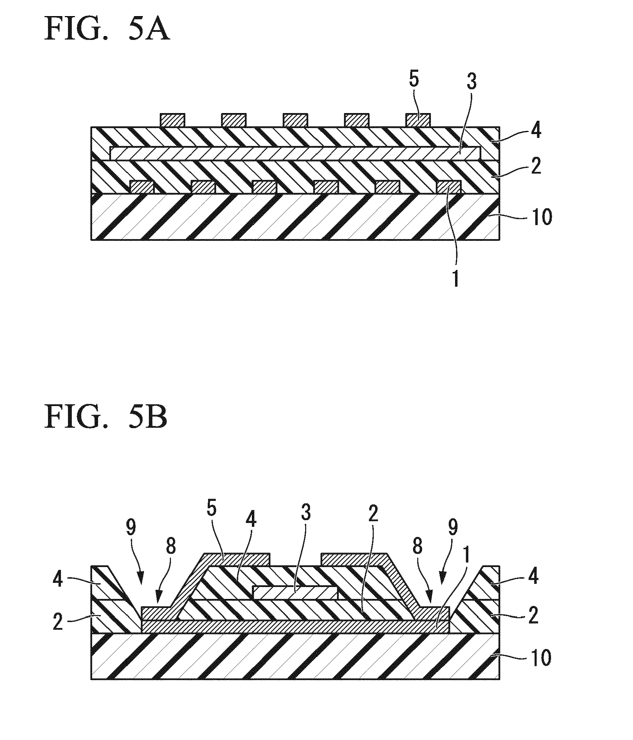

FIG. 4 is a plan view illustrating a schematic configuration of a thin film flux gate sensor. FIG. 5A and FIG. 5B are sectional views of the thin film flux gate sensor illustrated in FIG. 4. FIG. 5A illustrates part A-A of the thin film flux gate sensor illustrated in FIG. 4. FIG. 5B illustrates part B-B of the thin film flux gate sensor illustrated in FIG. 4.
As illustrated in FIG. 4, FIG. 5A, and FIG. 5B, the thin film flux gate sensor includes a first wiring layer 1, a first insulating layer 2, a magnetic film 3, a second insulating layer 4, and a second wiring layer 5. In addition, although not illustrated in the figures, the thin film flux gate sensor normally includes a protective layer that covers the second wiring layer 5.
A manufacturing method of the thin film flux gate sensor, for example, has been disclosed in Patent Document 1 and Patent Document 2. In the manufacturing methods disclosed in these Patent Documents, a metal film using aluminum (Al) and the like is formed as the first wiring layer 1. Then, as the first insulating layer 2, an inorganic oxide film using silicon oxide ($SiO_2$) and the like is formed by sputtering or CVD (Chemical Vapor Deposition). At this time, magnetic characteristics are degraded due to unevenness of the first wiring layer 1 serving as a base. Accordingly, after the first insulating layer 2 is thickly formed, a planarization process using etching back method or CMP (Chemical Mechanical Polishing) is needed. Furthermore, it is necessary to provide openings, which are for connection to the first wiring layer 1 serving as a base, in the first insulating layer 2 and the second insulating layer 4. A resist pattern is formed by photolithography, and then etching is performed by using a method of dry etching and the like. In the case of employing such a process, many man-hours are required and a large-scale manufacturing apparatus is needed. Therefore, the manufacturing cost of the sensor is increased.
In this regard, for example, Patent Document 3 has proposed and disclosed a thin film magnetic sensor using a photosensitive polyimide. By employing the photosensitive polyimide, an etching process of the insulating layer is not needed. Moreover, by coating the photosensitive polyimide, unevenness due to the base wiring is reduced, and the planarization process for the insulating layer is not needed. Therefore, it is possible to manufacture the sensor at a low cost.
Hereinafter, the manufacturing method of the thin film flux gate sensor configured as above will be schematically described with reference to FIG. 6A to FIG. 6E.
First, as illustrated in FIG. 6A, a seed layer is sputtered on a non-magnetic substrate 10 to form a resist mask, electrolytic plating is performed, and then the seed layer is removed by using etching. In this way, the first wiring layer 1 serving as the lower layer wiring of a solenoid coil is formed.
Next, as illustrated in FIG. 6B, the first wiring layer 1 is coated with photosensitive polyimide, and is exposed, developed, and thermally cured. In this way, the first insulating layer 2 with openings 8, through which the wiring of the solenoid coil is connected, is formed.
Moreover, as illustrated in FIG. 6C, after liftoff resist is formed on the first insulating layer 2, the magnetic film 3 is formed by sputtering and liftoff is performed, so that a core including a soft magnetic substance is formed.
Next, in order to remove residual stress incidental to the formation of the soft magnetic film, or irregular induced magnetic anisotropy generated due to a magnetic field in a sputtering apparatus, a heat treatment is performed in a rotating magnetic field or a static magnetic field.
Moreover, as illustrated in FIG. 6D, the magnetic film 3 is coated with photosensitive polyimide, and is exposed, developed, and thermally cured. In this way, the second insulating layer 4 with openings 9, through which the wiring of the solenoid coil is connected, is formed.
Subsequently, as illustrated in FIG. 6E, similarly to the first wiring layer 1, a seed layer is sputtered on the second insulating layer 4 to form a resist mask, electrolytic plating is performed, and then the seed layer is removed by using etching. In this way, the second wiring layer 5 serving as the upper layer wiring of the solenoid coil is formed. In addition, the second wiring layer 5 is provided with electrodes pad (not illustrated) for connection to terminals.
Finally, a protective film (not illustrated) formed with openings in electrodes portion for connection to an exterior is formed.

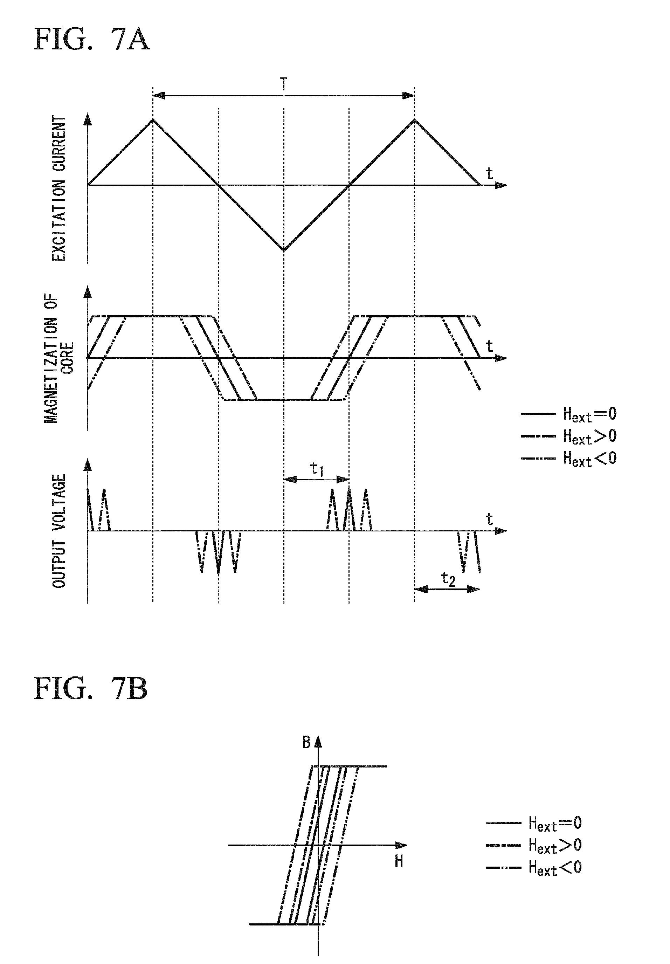

Here, the main point of an operation principle of the thin film flux gate sensor manufactured in the above procedure will be described with reference to FIG. 7A and FIG. 7B.

The sensor element manufactured as described above is formed of a solenoid-like excitation coil and a pickup coil. Triangular wave current illustrated in an upper part of FIG. 7A is allowed to flow through the excitation coil. In FIG. 7A, a horizontal axis denotes a time t. In this way, a magnetic field $H_{exc}$ is generated around the excitation coil. A middle part of FIG. 7A is a graph illustrating a change in a magnetization of the core excited by the magnetic field $H_{exc}$ of the excitation coil. Here, the excitation coil has B-H characteristics illustrated in FIG. 7B. When an excitation current is above or below a constant value according to the B-H characteristics, the magnetization is saturated and reaches the constant value. At this time, as illustrated in a lower part of FIG. 7A, at a zero cross point of the magnetization in the core, a spike-like voltage is generated at the pickup coil.

Here, when no external magnetic field $H_{ext}$ is applied ($H_{ext}$=0), the magnetization of the core is indicated by a solid line of the middle part of FIG. 7A. The voltage of the pickup coil is indicated by a solid line of the low part of FIG. 7A. Next, the case in which the external magnetic field $H_{ext}$ is applied ($H_{ext}$<0 or $H_{ext}$>0) is considered. At this time, the magnetization characteristics are also changed as illustrated in FIG. 7B according to the polarity of the external magnetic field $H_{ext}$. In FIG. 7B, a dashed dotted line indicates the case in which $H_{ext}$>0 and a double dot and dash line indicates the case in which $H_{ext}$<0. Accordingly, the magnetization characteristics of the core are also changed as illustrated in the middle part of FIG. 7A according to the polarity of the external magnetic field $H_{ext}$. In the middle part of FIG. 7A, a dashed dotted line indicates the case in which $H_{ext}$>0 and a double dot and dash line indicates the case in which $H_{ext}$<0. Moreover, a temporal position, at which the spike-like voltage is generated at the voltage of the pickup coil, is also changed as illustrated in the lower part of FIG. 7A according to the polarity of the external magnetic field $H_{ext}$. In the lower part of FIG. 7A, similarly to the above, a dashed dotted line indicates the case in which $H_{ext}$>0 and a double dot and dash line indicates the case in which $H_{ext}$<0. As compared with the case in which no external magnetic field is applied, when the external magnetic field $H_{ext}$ is applied ($H_{ext}$<0 or $H_{ext}$>0), temporally preceding or succeeding shift occurs. Accordingly, from a time interval of spike-like waveforms of the voltage of the pickup coil, the size and direction of the external magnetic field $H_{ext}$ can be recognized.

At this time, in the lower part of FIG. 7A, a time $t_1$ is expressed by Equation (1) and a time $t_2$ is expressed by Equation (2). In Equation (1) and (2), $H_c$ denotes coercive force of the excitation coil and $T_d$ denotes a delay time. Thus, when ($t_2$-$t_1$) is calculated, so that Equation (3) is obtained.

[Equation 1]

$$t_1 = \left( \frac{H_{exc} + H_c - H_{exc}}{H_{exc}} \right) \frac{T}{4} + T_d \qquad (1)$$

$$t_2 = \left( \frac{H_{exc} + H_c - H_{exc}}{H_{exc}} \right) \frac{T}{4} + T_d \qquad (2)$$

$$t_2 - t_1 = \frac{H_{exc}}{H_{exc}} \frac{T}{2} \qquad (3)$$

From Equation (3), it can be recognized that it is possible to remove the influence of hysteresis caused by the coercive force of the excitation coil. Moreover, digital detection using a counter is possible. Consequently, it is possible to remove the influence of an error at the time of analog/digital conversion. Thereby, it is possible to configure the sensor with good linearity.

At this time, the linearity of sensor output depends on the linearity of a current value of a triangular wave with respect to time and the linearity of magnetic flux density of the core for the excitation magnetic field generated by the excitation coil and the external magnetic field to be detected. A generation time interval of a pickup voltage for the external magnetic field is changed along the magnetization curve of the magnetic film. Thus, deterioration of the linearity of the magnetization curve directly affects deterioration of the linearity of the sensor output.

Accordingly, it is said that the coercive force is theoretically offset, but it is preferable that a material with good linearity of the magnetization curve be used as a material of the magnetic film. As such a material, for example, there are Co-based amorphous materials such as CoFeSiB, CoNbZr, and CoTaZr, and soft magnetic materials such as NiFe and CoFe. As described above, when the soft magnetic substance with good linearity of the magnetization curve is used in the core, a sensor element with good linearity is obtained.

CITATION LIST

Patent Document 1: Japanese Patent Publication No. 2730467
Patent Document 2: PCT International Publication No. WO 2007-126164
Patent Document 3: Japanese Unexamined Patent Application, First Publication, No. 2008-275578

SUMMARY OF INVENTION

Problems to be Solved by the Invention

In the manufacturing process of the sensor, as described above, the first insulating layer 2 is formed by using the photosensitive polyimide, and then several processes of applying heat are performed. That is, temperatures in the processes are a film formation temperature when forming the magnetic film 3 (a magnetic layer), a processing temperature of the heat treatment in the magnetic field, and a temperature of the heat curing process for the polyimide when forming the second insulating layer 4. In addition, hereinafter, the highest temperature among the heat treatment temperatures in each process will be referred to as a "process temperature."

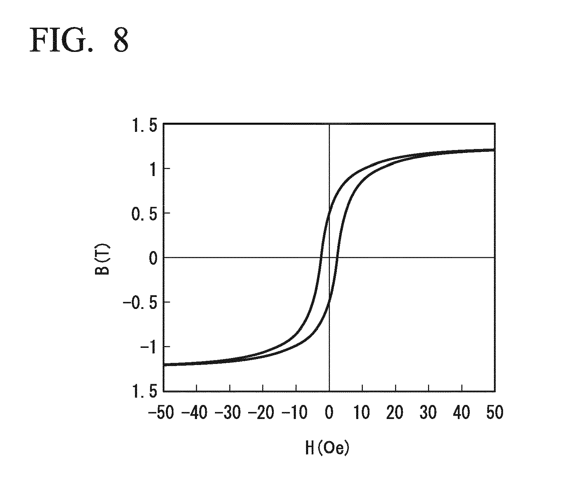

Here, when these heat treatment temperatures are higher than a glass transition temperature (Tg) of the first insulating layer 2 of the polyimide serving as the base on which the magnetic film is formed, the polyimide is contracted and modified, and the magnetic film 3 formed on the first insulating layer is also modified. As a consequence, since a stress state of the magnetic film 3 is changed, the characteristics of the magnetic film 3 are degraded. That is, as illustrated in a magnetization curve (a B-H curve) of FIG. 8, as coercive force is increased, the linearity of the magnetization curve is deteriorated. Furthermore, the linearity of output characteristics of a sensor using the magnetic film with the deteriorated linearity of the magnetization curve as described above is also deteriorated.

In the sensor with a deteriorated linearity of the output characteristics, particularly, in the case in which positive and negative magnetic fields are alternately applied as with an excitation magnetic field, changes in magnetic flux densities are different from each other when positive and negative magnetic fields are alternately applied such as the positive magnetic field is applied and then the negative magnetic field is applied or the negative magnetic field is applied and then the positive magnetic field is applied. Accordingly, the waveform of the pickup voltage when external magnetic fields are overlapped may be easily distorted. Furthermore, in the case in which a threshold voltage is provided by a hysteresis comparator and the like to detect a time, when waveform distortion becomes large by applying an external magnetic field, a time interval at which the pickup voltage reaches the threshold voltage is not linear for the external magnetic field, and the linearity of the output characteristics of the sensor is significantly deteriorated.

The present invention provides a manufacturing method of a flux gate sensor that does not damage the linearity of a magnetization curve of a magnetic layer (a magnetic film).

Means for Solving the Problems

A manufacturing method of a flux gate sensor may include at least: a first step of forming a first wiring layer on a substrate; a second step of forming a first insulating layer made of a first resin to cover the first wiring layer; a third step of forming a magnetic layer on the first insulating layer, the magnetic layer constituting a core of a flux gate; a fourth step of forming a second insulating layer made of a second resin on the first insulating layer to cover the magnetic layer; and a fifth step of forming a second wiring layer on the second insulating layer, wherein the first wiring layer and the second wiring layer are electrically connected to each other so that each of the first wiring layer and the second wiring layer constitutes a magnetic coil and a pickup coil, and at least a process temperature in each of the third, fourth, and fifth steps is lower than a glass transition temperature of the first resin.

The glass transition temperature of the first resin may be higher than 300°C.

A temperature of the process in the third step may be a higher temperature of a first temperature at a time of formation of the magnetic layer and a second temperature at a time of a heat treatment in a magnetic field which is performed after the magnetic layer is formed.

The third step may include a first process of forming a cobalt-based amorphous soft magnetic film by a sputtering method, and a second process of performing the heat treatment in the magnetic field and controlling induced magnetic anisotropy in the formed magnetic layer.

The first and second resins may be the same photosensitive polyimide. A heat curing temperature of the first

4

resin may be 350°C to 400°C, and a heat curing temperature of the second resin may be 250°C to 300°C.

Effect of the Invention

According to the manufacturing method of the flux gate sensor of the present invention, the deterioration of the linearity of the magnetic characteristics caused by an increase in the coercive force of the magnetic film is suppressed, resulting in the obtainment of the flux gate sensor with good output characteristics.
According to the manufacturing method of the flux gate sensor of the present invention, it is also possible to exclude the influence of the heat curing temperature when forming the second insulating layer.
According to the manufacturing method of the flux gate sensor of the present invention, it is possible to employ a temperature (250°C to 300°C) sufficient as the heat curing temperature when forming the second insulating layer.
The manufacturing method of the flux gate sensor of the present invention can be applied regardless of magnitude of the film formation temperature and a temperature of the heat treatment in the magnetic field.
According to the manufacturing method of the flux gate sensor of the present invention, it is possible to specify the process of forming the magnetic layer.
According to the manufacturing method of the flux gate sensor of the present invention, it is possible to employ a resin, which is different from the resin of the second insulating layer and has a high heat curing temperature, as the resin of the first insulating layer.

BRIEF DESCRIPTION OF THE DRAWINGS

FIG. 1 is a flowchart illustrating a procedure in a manufacturing method of a flux gate sensor in accordance with a first preferred embodiment of the present invention.
FIG. 2 is a diagram illustrating a relation between a heat treatment temperature in a magnetic field and coercive force in a CoNbZr film formed on two types of polyimide with different glass transition temperatures (Tg).
FIG. 3A is a diagram illustrating a magnetization curve of a magnetic film of a flux gate sensor obtained by a manufacturing method in accordance with the first preferred embodiment of the present invention.
FIG. 3B is a diagram illustrating output characteristics of a flux gate sensor obtained by a manufacturing method in accordance with the first preferred embodiment of the present invention.
FIG. 4 is a plan view illustrating a schematic configuration of a thin film flux gate sensor.
FIG. 5A is a sectional view of a thin film flux gate sensor illustrated in FIG. 4.
FIG. 5B is a sectional view of a thin film flux gate sensor illustrated in FIG. 4.
FIG. 6A is a diagram for describing a manufacturing process of a thin film flux gate sensor.
FIG. 6B is a diagram for describing a manufacturing process of a thin film flux gate sensor.
FIG. 6C is a diagram for describing a manufacturing process of a thin film flux gate sensor.
FIG. 6D is a diagram for describing a manufacturing process of a thin film flux gate sensor.
FIG. 6E is a diagram for describing a manufacturing process of a thin film flux gate sensor.
FIG. 7A is a diagram for describing the main point of an operation principle.
FIG. 7B is a diagram for describing the main point of an operation principle.
FIG. 8 is a diagram for describing problems of a thin film flux gate sensor in accordance with the related art.

BEST MODE FOR CARRYING OUT THE INVENTION

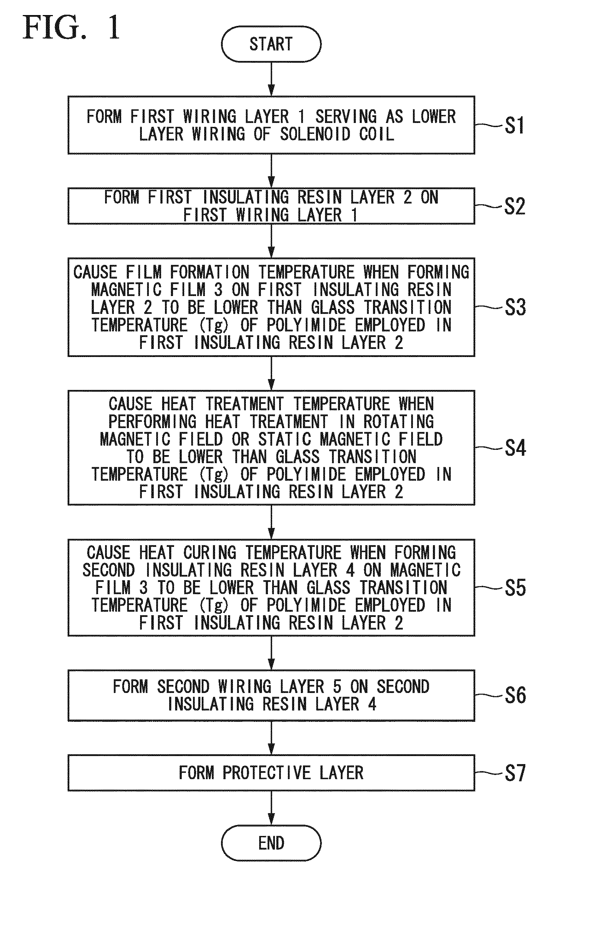

Hereinafter, preferred embodiments of the present invention will be described with reference to the accompanying drawings.
In the following description, the highest temperature among temperatures to be applied in each process (step) will be referred to as a "process temperature."
FIG. 1 is a flowchart illustrating a procedure of a manufacturing method of a flux gate sensor in accordance with a first preferred embodiment of the present invention.
According to the manufacturing method in accordance with the first preferred embodiment of the present invention, first, in step S1, a seed layer is sputtered on a non-magnetic substrate to form a photoresist mask, electrolytic plating is performed, and then the seed layer is removed by using etching. In this way, a first wiring layer 1 serving as a lower layer wiring of a solenoid coil is formed.
Next, in step S2, the first wiring layer 1 is coated with photosensitive polyimide, and is exposed, developed, and thermally cured. In this way, a first insulating layer 2 with openings, through which a wiring of the solenoid coil is connected, is formed. The higher a heat curing temperature at this time is, the higher a glass transition temperature (Tg) of the polyimide is. A temperature of about 350°C to about 400°C is preferable since pyrolysis of the polyimide starts at a temperature greater than or equal to about 400°C.

Next, in step S3, after liftoff resist is formed on the first insulating layer 2, a magnetic film 3 is formed by sputtering, and liftoff is performed. In this way, a core including a soft magnetic substance is formed. In the first preferred embodiment of the present invention, the film formation temperature when forming the magnetic film 3 is set to be lower than the glass transition temperature (Tg) of the polyimide employed in the first insulating layer 2. In addition, as the magnetic film 3 used at this time, a Co-based amorphous material such as CoFeSiB, CoNbZr, or CoTaZr, and a soft magnetic material such as NiFe or CoFe are preferable.

Next, in step S4, in order to remove residual stress incidental to the formation of the soft magnetic film, or irregular induced magnetic anisotropy generated due to a magnetic field in a sputtering apparatus, a heat treatment is performed in a rotating magnetic field or a static magnetic field. In the first preferred embodiment of the present invention, similarly to step S3, the temperature of the heat treatment in the magnetic field is set to be lower than the glass transition temperature (Tg) of the polyimide employed in the first insulating layer 2.

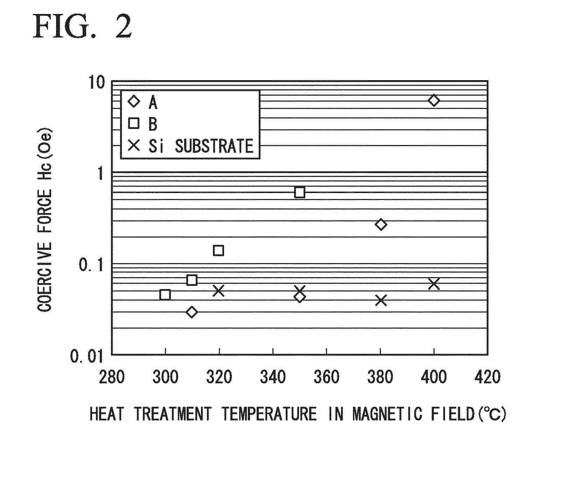

FIG. 2 illustrates a relation between a heat treatment temperature in a magnetic field and coercive force in a CoNbZr film formed on two types of polyimide with different glass transition temperatures (Tg). FIG. 2 illustrates two types of polyimide A and B and a silicon substrate. In FIG. 2, glass transition temperatures (Tg) of the polyimide A is 350°C, and glass transition temperatures (Tg) of the polyimide B is 320°C.

As illustrated in FIG. 2, in the case of the polyimide A, the coercive force is increased when the heat treatment temperature in the magnetic field exceeds 350°C. In the case of the polyimide B, the coercive force is increased when the heat treatment temperature in the magnetic field exceeds 320°C. That is, in both cases, when the heat treatment temperature in the magnetic field exceeds the glass transition temperature, the coercive force is increased, and the linearity of the magnetization curve is highly likely to be deteriorated. The base polyimide provided with the coercive magnetic film is softened through a heat treatment at a temperature exceeding the glass transition temperature, and an elastic modulus is significantly reduced. Therefore, distortion due to the stress of the magnetic film formed on the base polyimide is very large. Thus, it is considered that anisotropic energy of the magnetic film is increased due to an inverse magnetostriction effect, and coercive force is increased.

In addition, in the case in which a CoNbZr film is formed on the silicon substrate, the coercive force is small as it is even when the heat treatment temperature in the magnetic field is 400°C.

From the above, for example, in the case of employing the polyimide A, the heat treatment temperature in the magnetic field is set to be less than or equal to 350°C, and in the case of employing the polyimide B, the heat treatment temperature in the magnetic field is set to be less than or equal to 320°C. In this way, it is possible to suppress an increase in the coercive force in the magnetization curve of the magnetic film, and the deterioration of linearity is suppressed. Furthermore, since the increase in the coercive force is caused due to the above reasons, not only the heat treatment temperature in the magnetic field but also temperatures of heat treatments in processes to be performed after the process of forming the magnetic film are preferably lower than the glass transition temperature of the resin employed in the first insulating layer 2.

Returning to the procedure of the manufacturing method of FIG. 1, in step S5, the magnetic film 3 is coated with photosensitive polyimide, and is exposed, developed, and thermally cured. In this way, a second insulating layer 4 with openings, through which the wiring of the solenoid coil is connected, is formed. In the first preferred embodiment of the present invention, a heat curing temperature at this time is also set to be lower than the glass transition temperature (Tg) of the polyimide employed in the first insulating layer 2. In addition, since the heat curing process suppresses a change in the characteristics of the magnetic film caused by heat, it is preferable to perform the heat curing process in the state in which a rotating magnetic field or a static magnetic field has been applied.

Subsequently, in step S6, similarly to the first wiring layer 1, a seed layer is sputtered on the second insulating layer 4 to form a resist mask, electrolytic plating is performed, and then the seed layer is removed by using etching. In this way, a second wiring layer 5 serving as the upper layer wiring of the solenoid coil is formed. In addition, the second wiring layer 5 is provided with an electrode pad (not illustrated) for connection to an exterior.

Finally, in step S7, a protective film (not illustrated) with openings, which is in the electrode portion for connection to an exterior, is formed. In addition, even when forming the protective film, it is preferable that a heat curing temperature thereof is also set to be lower than the glass transition temperature (Tg) of the polyimide employed in the first insulating layer 2, and it is preferable that a process thereof is performed in the state in which a rotating magnetic field or a static magnetic field has been applied.

Based on FIG. 1, in the above-mentioned manufacturing method, the configuration (hereinafter, referred to as a "configuration A"), in which the first wiring layer 1 serving as the lower layer wiring of the solenoid coil and the second wiring layer 5 serving as the upper layer wiring of the solenoid coil are electrically connected to each other through the openings formed in each of the first insulating layer 2 and the second insulating layer 4, has been described in detail. However, instead of the configuration A, it may be possible to employ a configuration in which an insulating layer including the first insulating layer 2 and the second insulating layer 4 is provided only in an inner space of the solenoid coil including the first wiring layer 1 and the second wiring layer 5, and the magnetic film 3 is included in the first insulating layer 2 and the second insulating layer 4. That is, it may be possible to employ a configuration (not illustrated; hereinafter referred to as a "configuration B") in which the second wiring layer 5 is provided along outer peripheral surfaces of the first insulating layer 2 and the second insulating layer 4 stacked on the first insulating layer 2, and is electrically connected to the first wiring layer 1. The configuration B, for example, may be obtained by forming the first insulating layer 2 and the second insulating layer 4 such that both ends of the first wiring layer 1 are exposed, then forming the resist mask in step S6 on the second insulating layer 4 and the first wiring layer 1, then performing electrolytic plating, and then removing the seed by etching.

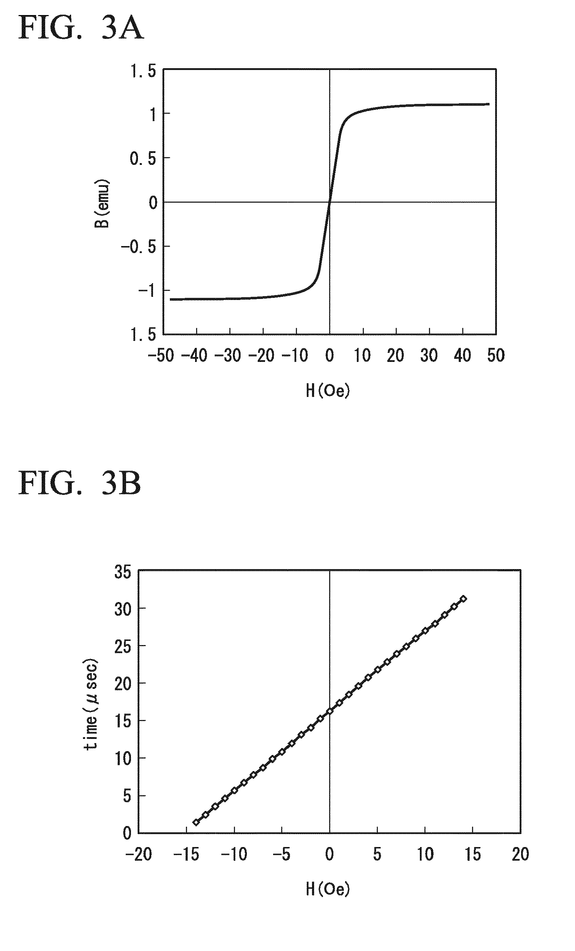

For the flux gate sensor employing $Co_{85}Nb_{12}Zr_3$ as a material of the magnetic film and manufactured based on the above-described manufacturing method, a magnetization curve (a B-H curve) of the magnetic film after the manufacturing process is performed is illustrated in FIG. 3A. As illustrated in FIG. 3A, good linearity is maintained. Furthermore, the output characteristics of the sensor at this time are illustrated in FIG. 3B. As illustrated in FIG. 3B, when the linearity of the magnetic film is maintained, good output characteristics are maintained.

As described above, the film formation temperature, a processing temperature of the heat treatment in the magnetic field, the processing temperature of the heat curing process of the second insulating layer, and the like are set to be lower than the glass transition temperature (Tg) of the polyimide employed in the first insulating layer, so that the deterioration of the linearity of the magnetic characteristics caused by an increase in the coercive force of the magnetic film is suppressed, and a flux gate sensor with good output characteristics can be obtained.

In addition, when the heat curing temperature of the polyimide is low, since it is difficult to sufficiently ensure resistance to a chemical solution in a process, the heat curing temperature is preferably about 250°C to about 300°C. Furthermore, a solder reflow temperature at the time of an assembly process of a sensor module or mounting of the sensor on the substrate is about 260°C. When the glass transition temperature of the resin employed in the first insulating layer is lower than the solder reflow temperature, since the coercive force of the magnetic film is increased by heating at the time of solder reflow, the linearity of the magnetic characteristics of the sensor is deteriorated. Accordingly, it is preferable that the glass transition temperature of the resin employed in the first insulating layer be sufficiently higher than the solder reflow temperature.

Thus, from these limitations, it is suitable that the glass transition temperature (Tg) of the polyimide employed in the first insulating layer be greater than or equal to 300°C. That is, the flux gate sensor with superior resistance to the reflow temperature and good output characteristics is obtained.

In addition, the above-described preferred embodiment is an example, and various embodiments for realizing the scope of the present invention can be made by those skilled in the art.

For example, in the above-described preferred embodiment, the case in which the photosensitive polyimide is employed as the insulating layer has been described. However, the present invention is not limited thereto. For example, it may be possible to employ a photosensitive resin material such as polybenzoxazole or cresol novalac resin.

However, in terms of material management in a process, the first insulating layer and the second insulating layer are preferably made of the same material. Accordingly, from the above description, in such a case, a material is used that the glass transition temperature (Tg) thereof is greater than or equal to 300°C, and a heat curable temperature thereof is a temperature of about 250°C to about 300°C. Here, as described in step S2, a heat curing temperature for the material employed in the first insulating layer is preferably about 350°C to about 400°C.

Furthermore, in the abovementioned embodiment, the photosensitive polyimide, which is a photosensitive material, has been described. However, non-photosensitive polyimide may be employed if pattern formation is possible by a micro fabrication process such as photolithography or nanoimprint. The non-photosensitive polyimide generally has a higher glass transition temperature than the photosensitive polyimide, and a non-photosensitive polyimide with a glass transition temperature of about 400°C also exists. Accordingly, in the case of employing the non-photosensitive polyimide, it is possible to set the temperature limited in the present invention to about 400°C.

Furthermore, in the above-described preferred embodiment, the electrolytic plating method is used as the wiring formation method. However, the wirings may be formed by etching a conductive material such as aluminum (Al), gold (Au), or copper (Cu) formed using electroless plating or sputtering.

While preferred embodiments of the present invention have been described and illustrated above, it should be understood that these are examples of the present invention and are not to be considered as limiting. Additions, omissions, substitutions, and other modifications can be made without departing from the scope of the present invention. Accordingly, the present invention is not to be considered as being limited by the foregoing description, and is only limited by the scope of the claims.

INDUSTRIAL APPLICABILITY

The manufacturing method of the present invention can be applied to a thin film flux gate sensor employed in an electronic azimuth meter used in a cellular phone and the like. Furthermore, the manufacturing method of the present invention can be applied to a current sensor that detects a magnetic field generated by a current to measure a current value, a magnetic rotary encoder, or a thin film flux gate sensor employed in a linear encoder. Furthermore, the manufacturing method of the present invention can be applied to a thin film flux gate sensor employed in an apparatus that detects magnetic particles including a magnetic material or foreign substances.

DESCRIPTION OF THE REFERENCE SYMBOLS

1    first wiring layer
2    first insulating layer
3    magnetic layer (magnetic film)
4    second insulating layer
5    second wiring layer
8    opening
9    opening
10   non-magnetic substrate

**Claims**

1. A manufacturing method of a flux gate sensor comprising at least:

   a first step of forming a first wiring layer on a substrate;
   a second step of forming a first insulating layer made of a first resin to cover the first wiring layer;
   a third step of forming a magnetic layer on the first insulating layer, the magnetic layer constituting a core of a flux gate;
   a fourth step of forming a second insulating layer made of a second resin on the first insulating layer to cover the magnetic layer; and
   a fifth step of forming a second wiring layer on the second insulating layer,
   wherein the first wiring layer and the second wiring layer are electrically connected to each other so that each of the first wiring layer and the second wiring layer constitutes a magnetic coil and a pickup coil, and
   at least a process temperature in each of the third, fourth, and fifth steps is lower than a glass transition temperature of the first resin.

2. The manufacturing method of a flux gate sensor according to claim 1, wherein the glass transition temperature of the first resin is higher than 300°C.

3. The manufacturing method of a flux gate sensor according to claim 1, wherein a temperature of the process in the third step is a higher temperature of a first temperature at a time of formation of the magnetic layer and a second temperature at a time of a heat treatment in a magnetic field which is performed after the magnetic layer is formed.

4. The manufacturing method of a flux gate sensor according to claim 2, wherein the third step includes a first process of forming a cobalt-based soft magnetic film by a sputtering method, and a second process of performing the heat treatment in the magnetic field and controlling induced magnetic anisotropy in the formed magnetic layer.

5. The manufacturing method of a flux gate sensor according to any one of claims 1 to 4, wherein the first and second resins are the same photosensitive polyimide, a heat curing temperature of the first resin is 350°C to 400°C, and a heat curing temperature of the second resin is 250°C to 300°C.

# FIG. 1

```
                    ┌──────────────┐
                    │    START     │
                    └──────┬───────┘
                           ↓
┌─────────────────────────────────────────────┐
│  FORM FIRST WIRING LAYER 1 SERVING AS LOWER  │──── S1
│      LAYER WIRING OF SOLENOID COIL           │
└─────────────────────┬───────────────────────┘
                      ↓
┌─────────────────────────────────────────────┐
│    FORM FIRST INSULATING RESIN LAYER 2 ON    │──── S2
│           FIRST WIRING LAYER 1               │
└─────────────────────┬───────────────────────┘
                      ↓
┌─────────────────────────────────────────────┐
│ CAUSE FILM FORMATION TEMPERATURE WHEN FORMING│
│ MAGNETIC FILM 3 ON FIRST INSULATING RESIN    │
│ LAYER 2 TO BE LOWER THAN GLASS TRANSITION    │──── S3
│ TEMPERATURE (Tg) OF POLYIMIDE EMPLOYED IN    │
│      FIRST INSULATING RESIN LAYER 2          │
└─────────────────────┬───────────────────────┘
                      ↓
┌─────────────────────────────────────────────┐
│    CAUSE HEAT TREATMENT TEMPERATURE WHEN     │
│    PERFORMING HEAT TREATMENT IN ROTATING     │
│   MAGNETIC FIELD OR STATIC MAGNETIC FIELD    │
│      TO BE LOWER THAN GLASS TRANSITION       │──── S4
│  TEMPERATURE (Tg) OF POLYIMIDE EMPLOYED IN   │
│      FIRST INSULATING RESIN LAYER 2          │
└─────────────────────┬───────────────────────┘
                      ↓
┌─────────────────────────────────────────────┐
│  CAUSE HEAT CURING TEMPERATURE WHEN FORMING  │
│ SECOND INSULATING RESIN LAYER 4 ON MAGNETIC  │
│  FILM 3 TO BE LOWER THAN GLASS TRANSITION    │──── S5
│  TEMPERATURE (Tg) OF POLYIMIDE EMPLOYED IN   │
│      FIRST INSULATING RESIN LAYER 2          │
└─────────────────────┬───────────────────────┘
                      ↓
┌─────────────────────────────────────────────┐
│    FORM SECOND WIRING LAYER 5 ON SECOND      │──── S6
│         INSULATING RESIN LAYER 4             │
└─────────────────────┬───────────────────────┘
                      ↓
┌─────────────────────────────────────────────┐
│           FORM PROTECTIVE LAYER              │──── S7
└─────────────────────┬───────────────────────┘
                      ↓
                    ┌──────────────┐
                    │     END      │
                    └──────────────┘
```

FIG. 2

# FIG. 3A

# FIG. 3B

FIG. 4

FIG. 5A

FIG. 5B

FIG. 6A

FIG. 6B

FIG. 6C

FIG. 6D

FIG. 6E

## FIG. 7A

## FIG. 7B

FIG. 8

## INTERNATIONAL SEARCH REPORT

| | International application No. |
|---|---|
| | PCT/JP2011/060939 |

**A. CLASSIFICATION OF SUBJECT MATTER**
*G01R33/04*(2006.01)i

According to International Patent Classification (IPC) or to both national classification and IPC

**B. FIELDS SEARCHED**

Minimum documentation searched (classification system followed by classification symbols)
G01R33/02-10, G01C17/28-32, G01C17/38

Documentation searched other than minimum documentation to the extent that such documents are included in the fields searched
| | | | |
|---|---|---|---|
| Jitsuyo Shinan Koho | 1922-1996 | Jitsuyo Shinan Toroku Koho | 1996-2011 |
| Kokai Jitsuyo Shinan Koho | 1971-2011 | Toroku Jitsuyo Shinan Koho | 1994-2011 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 2003-270310 A  (Samsung Electro-Mechanics Co., Ltd.), 25 September 2003 (25.09.2003), entire text; all drawings & US 2003/0169039 A1    & GB 2386197 A & GB 210670 D0          & DE 10220981 A & KR 10-2003-0073284 A   & TW 551021 B & CN 1444049 A | 1-5 |
| A | JP 2008-275578 A  (Fujikura Ltd.), 13 November 2008 (13.11.2008), entire text; all drawings (Family: none) | 1-5 |

| ☐ Further documents are listed in the continuation of Box C. | ☐ See patent family annex. |
|---|---|

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 05 July, 2011 (05.07.11) | 16 August, 2011 (16.08.11) |

| Name and mailing address of the ISA/ | Authorized officer |
|---|---|
| Japanese Patent Office | |
| Facsimile No. | Telephone No. |

Form PCT/ISA/210 (second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2010110229 A
- JP 2730467 B
- WO 2007126164 A
- JP 2008275578 A